# EUROPEAN PATENT SPECIFICATION

(11) **EP 3 823 014 B1**
(45) Date of publication and mention of the grant of the patent: **31.07.2024**
(21) Application number: 19209444.9
(22) Date of filing: 15.11.2019
(51) Int. Cl.: H01L 21/762, H01L 21/76, H01L 21/84, H01L 27/12, H01L 21/322

(54) **DEVICES INCLUDING RADIO FREQUENCY DEVICES AND METHODS**
VORRICHTUNGEN EINSCHLIESSLICH HOCHFREQUENZVORRICHTUNGEN UND -VERFAHREN
DISPOSITIFS COMPRENANT DES DISPOSITIFS DE FRÉQUENCE RADIO ET PROCÉDÉS

(43) Date of publication of application: 19.05.2021
(73) Proprietor: Infineon Technologies AG, 85579 Neubiberg (DE)
(72) Inventor: TADDIKEN, Hans, 81737 München (DE); KUEHN, Christian, 80339 München (DE); LEUSCHNER, Stephan, 13353 Berlin (DE)
(74) Representative: Kraus & Lederer PartGmbB

(56) References cited:
- JP-A- H 098 123
- US-A1- 2007 252 209
- US-A1- 2008 217 727
- US-A1- 2015 228 714

## Description

### TECHNICAL FIELD

The present application relates to devices including radio frequency (RF) devices and methods for manufacturing such devices.

### BACKGROUND

Radio frequency devices are for example used in communication circuits. Examples for radio frequency devices are transistor-based radio frequency switches, which in some implementations may be formed by coupling a plurality of transistors in series. Other examples may include passive radio frequency devices. Radio frequency, as used herein, may relate to frequencies above 100 kHz, in particular in the MHz range or GHz range. For example, for the upcoming 5G (5^{th} generation) mobile communication standard frequencies up to 300 GHz will be used. In some cases, to improve performance, radio frequency devices are manufactured on silicon on insulator (SOI) substrates.

For such radio frequency devices, specification requirements are becoming more and more strict. For example, an improved linearity of the devices may be required.

Examples of radio frequency devices manufactured on SOI substrates are disclosed in: SI US 2007252209 A1, JP H09 8123 A, US 2015228714 A1 and US 2008/217727 A1.

### SUMMARY

According to some embodiment, methods and devices as defined in the independent claims are provided. The dependent claims defined further embodiments.

According to an embodiment, a method is provided, comprising:
forming a radio frequency device at an active layer of a silicon on insulator substrate,
forming an insulation region in a region around the radio frequency device,
forming silicon filler regions in the insulation region, and
forming polysilicon filler regions above the insulation region, wherein the polysilicon filler regions are provided at different positions than the silicon filler regions in a top view on the substrate, wherein the silico filler regions are undoped.

According to a further embodiment, a device is provided, comprising:
a silicon on insulator substrate,
a radio frequency device at an active layer of the silicon on insulator substrate,
in the active layer, an insulation region around the radio frequency device,
silicon filler regions in the insulation region, and
polysilicon filler regions above the insulation region, wherein the polysilicon filler regions are provided at different positions than the silicon filler regions in a top view on the substrate, and wherein the silicon filler regions are undoped.

The above summary is merely intended to give a brief overview over some embodiments and is not to be construed as limiting in any way, as other embodiments may comprise other features than the ones explicitly mentioned above.

### BRIEF DESCRIPTION OF THE DRAWINGS

Fig. 1 is a flow chart illustrating a method which does not form part of the invention as claimed.
Fig. 2 is a cross-sectional view illustrating a device which does not form part of the invention as claimed.
Fig. 3 is a flow chart illustrating a method according to an embodiment.
Fig. 4A is a cross-sectional view illustrating a device according to an embodiment.
Fig. 4B is a top view of the device of Fig. 4A.
Fig. 5 is a cross-sectional view illustrating a device according to a further embodiment.

### DETAILED DESCRIPTION

In the following, various embodiments will be described in detail referring to the attached drawings.

It is to be understood that these embodiments are given for illustrative purposes and are not to be construed as limiting in any way. For example, while embodiments may be described as comprising a plurality of features, elements, process steps and the like, in other embodiments, some of these features, elements or process steps may be omitted or replaced by alternative features, elements or process steps, within the scope of the appended claims.

In addition to the features, elements or process steps explicitly shown and described, other features, elements or process steps may be provided, for example features, elements or process steps used in conventional radio frequency devices and manufacturing thereof.

Embodiments use silicon on insulator wafers and substrates. Silicon on insulator wafers and substrates are layered wafers and substrates which may be used for example to reduce parasitic capacitances within devices, for example radio frequency devices. Silicon on insulator wafers generally comprise at least a supporting silicon substrate, an active silicon layer and an oxide layer between the active silicon layer and the supporting silicon substrate. The active silicon layer denotes the silicon layer at which devices are formed. "At" the active silicon layer in this case means in the active silicon layer, for example by modifying portions of the active silicon layer by techniques like ion implantation, etching and the like, and/or on top of the active silicon layer, for example by depositing or structuring additional layers on the active silicon layer. In some silicon on insulator wafers, additional layers may be present, for example a trap-rich layer, like a polysilicon layer between the oxide layer and the supporting silicon substrate. Various techniques are used to manufacture silicon on insulator substrate, like wafer bonding techniques or oxygen implantation techniques. As such silicon on insulator substrates and wafers or commercially available, they will not be further described here.

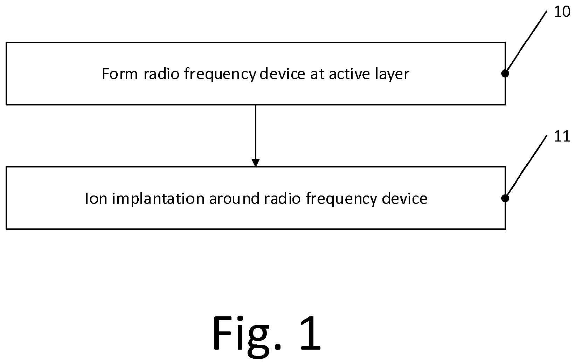

Fig. 1 is a flow chart illustrating a method for manufacturing a device according to an example which does not form part of the invention as claimed.

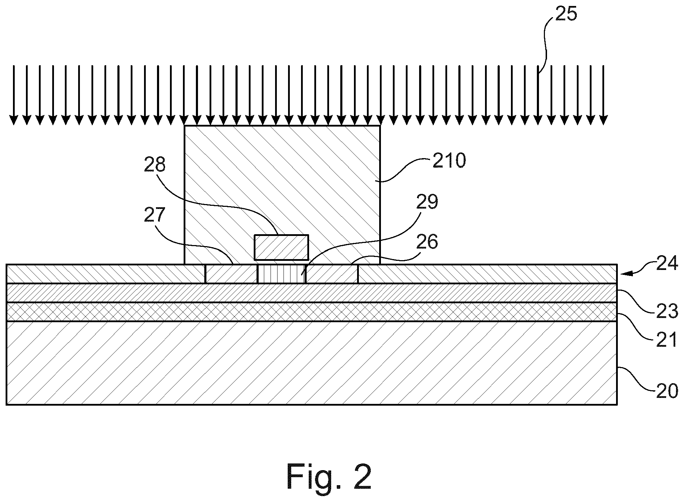

For better understanding, the method of Fig. 1 will be described also referring to Fig. 2, which shows a cross-sectional view of a device at a particular stage of processing in an example implementation of a method as shown in Fig. 1. It should nevertheless be noted that the method of Fig. 1 and the device of Fig. 2 may also be implemented independently from each other, and the joint description merely serves to provide a better understanding.

The method shown in Fig. 1, at 10, comprises forming a radio frequency device at an active layer of a silicon on insulator substrate. As an example, Fig. 2 shows a silicon on insulator substrate which includes a supporting silicon substrate 20, a buried oxide layer 23 and an active silicon layer 24. The supporting silicon substrate 20 may have a comparatively high resistance (corresponding to a low dopant concentration) of 300 Ωcm to 1 kΩcm or more, but is not restricted thereto.

In the example of Fig. 2, between buried oxide layer 23 and supporting silicon substrate 20, a trap-rich layer 21 is provided which serves to trap free charge carriers at interfaces, for example at the interface between oxide 23 and trap-rich layer 21 or at the interface between trap-rich layer 21 and supporting silicon substrate 20.

Active layer 24 is the layer at, i.e. in and/or on, which devices like a radio frequency device are formed. As an example, in Fig. 2 a field effect transistor is formed as a radio frequency device. To form the transistor, a source region 27 and a drain region 26 are formed in active layer 24 separated by a body region 29. In some implementations, source and drain regions 27, 26 may be formed by doping for example using ion implantation (n-type doping for an n-type transistor and p-type doping for a p-type transistor), while body region 29 has a low dopant concentration. For example, for forming an n-type field effect transistor, source and drain regions 27, 26 may be n-type doped using phosphorous or arsenic, while body region may be weakly p-doped.

Furthermore, a polysilicon gate, 28, is formed above body region 29 separated from active layer 24, in particular body region 29, by a gate dielectric like a silicon oxide layer. In other implementations, a metal gate may be formed. In some implementations, a plurality of such transistors may be formed and coupled in series to provide a radio frequency switch. The transistor shown in Fig. 2 is merely an example for a radio frequency device, and other devices, both active and passive may be formed as well in any conventional manner.

At 11, the method of Fig. 1 comprises an ion implantation around the frequency device. An ion implantation may create a defect rich region. Defects in the defect rich region may trap free charge carriers, which in some cases may help to improve linearity. For example, by ion implantation defects are formed which provide recombination centers reducing lifetime of charge carriers like minority carriers, thus reducing the number of free charge carriers. Energy levels of such recombination centers may be at or near an intrinsic Fermi level. For example, Argon may form a deep level at 0.5 eV. A defect rich region is to be understood as a region where sufficient defects are formed to reduce the density of free charge carriers.

In the example of Fig. 2, for performing the ion implantation a photoresist layer 210 is formed above the radio frequency transistor. Then an ion implantation, for example an argon ion implantation, is performed as indicated by arrows 25. By the photoresist 210, a region of the radio frequency transistor (or other radio frequency device in other implementations) is protected against the ion implantation, whereas a region around the radio frequency transistor is implanted with ions like argon ions, to form a defect rich region. Typical Argon doses may be in the range of 5×10¹⁴/cm² to 2×10¹⁵/cm² with an energy between 120keV and 500keV, but are not limited thereto. Furthermore, doses may depend on the type of ions used.

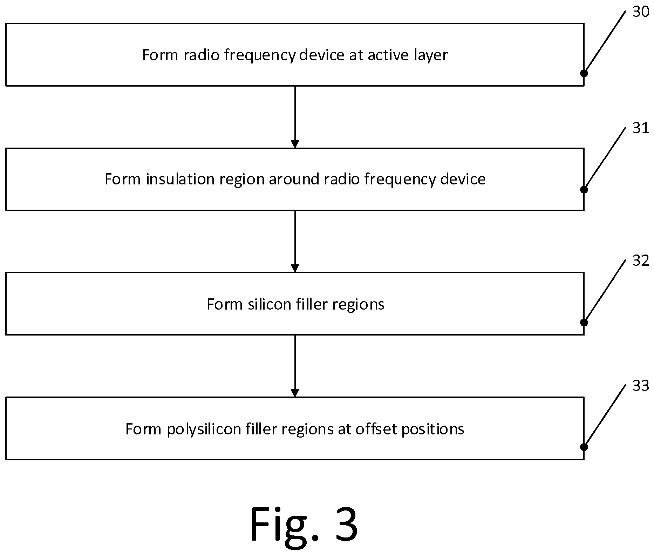

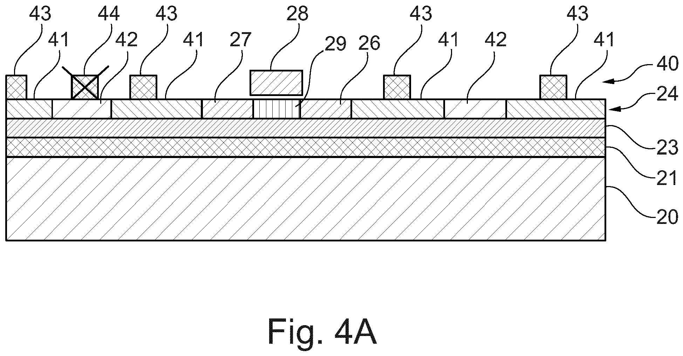

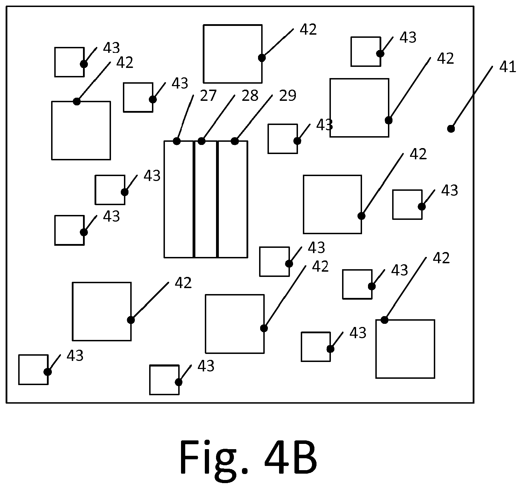

Fig. 3 illustrates a method according to an embodiment. The method of Fig. 3 will be explained jointly with a device illustrated in Figs. 4A and 4B, where Fig. 4A shows a cross-sectional view and Fig. 4B shows a top view of a device according to an embodiment. Features corresponding to features already explained with reference to Fig. 2 bear the same reference numeral in Figs. 4A and 4B and will not be described again in detail.

It should be noted that the various acts and events described with reference to Fig. 3 are not necessarily performed in the order shown and described, but depending on processing technologies, other orders may be used or certain parts of the various acts and events may be performed simultaneously. Examples for this will be given in the course of the description of Fig. 3.

At 30, the method illustrated in Fig. 3 comprises forming a radio frequency device at an active layer of a silicon on insulator substrate. This forming of a radio frequency device at 30 may correspond to the forming of a radio frequency device at 10 in Fig. 1, and the variations and possibilities for forming such a device explained with reference to Figs. 1 and 2 also apply to the forming at 30 in Fig. 3.

In the example device of Figs. 4A and 4B, as in Fig. 2 a silicon on insulator substrate comprising a supporting silicon substrate 20, a trap-rich layer 21, a buried oxide layer 23 and an active layer 24 is used. As an example for a radio frequency device, as in Fig. 2 a radio frequency transistor having a source region 27, a drain region 26 and a polysilicon gate 28 above a body region 29 is used. Polysilicon gate 28 is part of a polysilicon layer 40 above active layer 24.

At 31 in Fig. 3, an insulation region is formed around the radio frequency device, in particular in the active layer. As an example, in Figs. 4A and 4B a shallow trench insulation (STI) region 41 is formed around the radio frequency device.

At 32, silicon filler regions are formed in the insulation region. For example, in Fig. 4A silicon filler regions 42 are formed. These regions may be randomly distributed within the insulation region, as indicated by an irregular distribution as seen in the top view of Fig. 4B. Generally, such filler regions are used in semiconductor device manufacturing to facilitate manufacturing of the device. It should be noted that the forming of the silicon filler regions may be effected by forming the insulation region in the active layer 24 apart from the silicon filler regions, such that the silicon filler regions are formed by remaining silicon of the original active layer of the silicon on insulator substrate. In other words, the forming of the silicon filler regions may also happen implicitly in the processing, by leaving certain regions of silicon unprocessed when forming the insulation region. Such an implicit forming is also to be regarded as "forming silicon filler regions" in the context of the present specification.

Typical sizes of such silicon filler regions may be of the order of about 0.4×0.4 µm², but larger or smaller structures or non-square structures may also be used. For example, sizes of up to 5×5µm² may be used. A density of the filler regions may be such that they cover about 4% of the area, but other values are also possible, for example up to 55%.

The silicon filler regions are undoped to reduce free charge carriers. "Undoped" in this case means that no intentional doping is performed. It is understood by the skilled person that some amount of impurities may nevertheless be present unintentionally which may cause some doping.

At 33, the method comprises forming polysilicon filler regions at offset positions to the silicon filler regions above the active layer, in particular in a polysilicon layer. In Fig. 4A, as an example polysilicon filler regions 43 are shown. Offset positions means that the polysilicon filler regions, in a top view of the substrate (for example top view of Fig. 4B) are formed at different positions compared to the silicon filler regions. In the embodiment of Figs. 4A and 4B, in particular the polysilicon filler regions 43 are formed without overlap with the silicon filler regions in the top view of Fig. 4B. In other words, no polysilicon filler regions are formed above the silicon filler regions, as shown for crossed-out polysilicon filler region 44 in Fig. 4A.

If a direction parallel to the surface of the substrate is taken as lateral direction, as often used in semiconductor technology, it can also be said that the polysilicon filler regions are formed laterally offset or at laterally different positions, in particular without lateral overlap to the silicon filler regions.

Forming of the polysilicon filler regions also may facilitate processing of the devices. It should be noted that the polysilicon filler regions may be formed in the same process as the polysilicon gate 28. This is an example where parts of various acts or events of the method of Fig. 3, in this case a part of forming the radio frequency device, and the forming of the polysilicon filler regions, are performed simultaneously.

Using the laterally offset positions may prevent or reduce the forming of free charge carriers which could otherwise be formed at interfaces between polysilicon filler regions and silicon filler regions. This, in turn, in some embodiments may help to increase linearity.

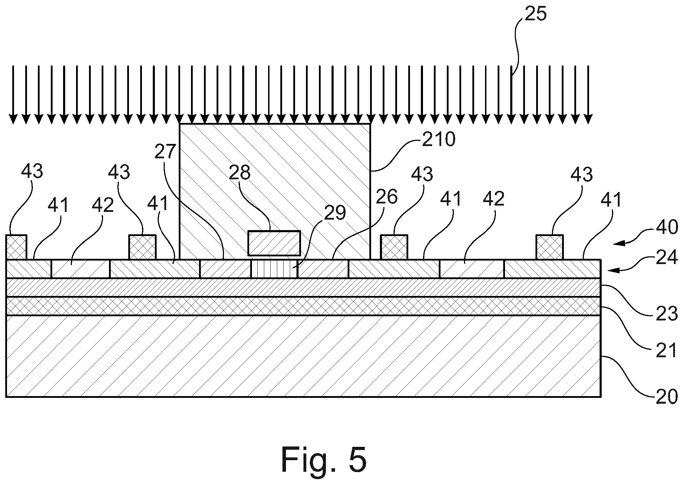

It should be noted that the methods of Figs. 1 and 3 may be combined, by performing both the ion implantation at 11 in Fig. 1 and forming the insulation region, silicon filler regions and polysilicon filler regions at 31 to 33 of Fig. 3. The ion implantation may be performed after forming the silicon filler regions and the polysilicon filler regions, such that these regions are also subjected to ion implantation like argon ion implantation. A corresponding device in a particular stage of processing is illustrated in Fig. 5. Fig. 5 is essentially a combination of Figs. 2 and 4A, and corresponding elements bear the same reference numerals. In particular, in Fig. 5 around the radio frequency transistor the shallow trench insulation region 41 with the silicon filler regions 42 is formed in active layer 24, and polysilicon filler regions 43 are formed at laterally offset positions to the silicon filler regions 42 in a polysilicon layer 40. The radio frequency transistor is protected by a photoresist 210 against ion implantation as indicated by arrows 25, such that at least a part of insulation region 41 outside photoresist 210 as well as polysilicon filler regions 43 and silicon filler regions 42 are ion implanted to form defect rich regions. The combination of these measures may further reduce free-charge carriers, leading to an increase of linearity in some implementations.

## Claims

1. A method, comprising:
forming a radio frequency device (26, 27, 28, 29) at an active layer (24) of a silicon on insulator substrate (20, 21, 22, 23),
forming an insulation region (41) in a region around the radio frequency device(26, 27, 28, 29),
forming silicon filler regions (42) in the insulation region (41), and
forming polysilicon filler regions (43) above the insulation region (41), wherein the polysilicon filler regions (43) are provided at different positions than the silicon filler regions (42) in a top view on the substrate,
wherein the silicon filler regions (42) are undoped.

2. The method of claim 1, wherein the polysilicon filler regions (43) are undoped.

3. The method of claim 1 or 2, further comprising ion implanting (25) a region around the radio frequency device (26, 27, 28, 29) to form a defect rich region to reduce a free charge carrier density after the forming of the insulation region.

4. The method of claim 3, wherein ion implanting (25) comprises implanting with Argon ions.

5. The method of claim 1 or 2, further comprising ion implanting (25) in at least some of the silicon filler regions (42) and/or the polysilicon filler regions (43) to form defect rich regions to reduce a free charge carrier density.

6. A device, comprising:
a silicon on insulator substrate (20, 21, 22, 23),
a radio frequency device (26, 27, 28, 29) at an active layer (24) of the silicon on insulator substrate (20, 21, 22, 23), in the active layer (24), an insulation region (41) around the radio frequency device (26, 27, 28, 29),
silicon filler regions (42) in the insulation region (41), and
polysilicon filler regions (43) above the insulation region (41), wherein the polysilicon filler regions (43) are provided at different positions than the silicon filler regions (42) in a top view on the substrate,
wherein the silicon filler regions (42) are undoped.

7. The device of claim 6, wherein the polysilicon filler regions (43) are undoped.

8. The device of claim 6 or 7, further comprising a defect rich region around the radio frequency device (26, 27, 28, 29), wherein the insulation region (41) at least partially overlaps with the defect rich region.

9. The device of claim 8, wherein the defect rich region comprises an ion implanted region.

## Patentansprüche

1. Verfahren, das Folgendes umfasst:
Bilden einer Hochfrequenzvorrichtung (26, 27, 28, 29) auf einer aktiven Schicht (24) eines Silizium-auf-Isolator-Substrats (20, 21, 22, 23),
Bilden eines Isolierungsgebiets (41) in einem Gebiet um die Hochfrequenzvorrichtung (26, 27, 28, 29),
Bilden von Siliziumfüllgebieten (42) in dem Isolierungsgebiet (41) und
Bilden von Polysiliziumfüllgebieten (43) über dem Isolierungsgebiet (41), wobei die Polysiliziumfüllgebiete (43) in einer Draufsicht des Substrats an anderen Positionen als die Siliziumfüllgebiete (42) bereitgestellt werden,
wobei die Siliziumfüllgebiete (42) undotiert sind.

2. Verfahren nach Anspruch 1, wobei die Polysiliziumfüllgebiete (43) undotiert sind.

3. Verfahren nach Anspruch 1 oder 2, ferner umfassend Ionenimplantieren (25) eines Gebiets um die Hochfrequenzvorrichtung (26, 27, 28, 29), um ein störstellenreiches Gebiet zu bilden, um eine Dichte freier Ladungsträger nach dem Bilden des Isolierungsgebiets zu reduzieren.

4. Verfahren nach Anspruch 3, wobei das Ionenimplantieren (24) Implantieren mit Aragon-Ionen umfasst.

5. Verfahren nach Anspruch 1 oder 2, ferner umfassend Ionenimplantieren (25) in mindestens einigen der Siliziumfüllgebiete (42) und/oder der Polysiliziumfüllgebiete (43), um störstellenreiche Gebiete zu bilden, um eine Dichte freier Ladungsträger zu reduzieren.

6. Vorrichtung, die Folgendes umfasst:
ein Silizium-auf-Isolator-Substrat (20, 21, 22, 23),
eine Hochfrequenzvorrichtung (26, 27, 28, 29) auf einer aktiven Schicht (24) des Silizium-auf-Isolator-Substrats (20, 21, 22, 23),
in der aktiven Schicht (24), ein Isolierungsgebiet (41) um die Hochfrequenzvorrichtung (26, 27, 28, 29),
Siliziumfüllgebiete (42) in dem Isolierungsgebiet (41) und Polysiliziumfüllgebiete (43) über dem Isolierungsgebiet (41), wobei die Polysiliziumfüllgebiete (43) in einer Draufsicht des Substrats an anderen Positionen als die Siliziumfüllgebiete (42) bereitgestellt sind,
wobei die Siliziumfüllgebiete (42) undotiert sind.

7. Vorrichtung nach Anspruch 6, wobei die Polysiliziumfüllgebiete (43) undotiert sind.

8. Vorrichtung nach Anspruch 6 oder 7, ferner umfassend ein störstellenreiches Gebiet um die Hochfrequenzvorrichtung (26, 27, 28, 29), wobei das Isolierungsgebiet (41) das störstellenreiche Gebiet zumindest teilweise überlappt.

9. Vorrichtung nach Anspruch 6, wobei das störstellenreiche Gebiet ein ionenimplantiertes Gebiet umfasst.

## Revendications

1. Procédé comprenant :
former un dispositif (26, 27, 28, 29) de fréquence radio à une couche (24) active d'un substrat (20, 21, 22, 23) silicium sur isolateur,
former une région (41) d'isolation dans une région autour du dispositif (26, 27, 28, 29) de fréquence radio,
former des régions (42) de matière de charge de silicium dans la région (41) d'isolation, et
former des régions (43) de matière de charge de polysilicium au-dessus de la couche (41) d'isolation, dans lequel les régions (43) de matière de charge de polysilicium sont prévues en des positions différentes de celles des régions de matière de charge de silicium dans une vue de dessus du substrat,
dans lequel les régions (42) de matière de charge de silicium ne sont pas dopées.

2. Procédé suivant la revendication 1, dans lequel les régions (43) de matière de charge de polysilicium ne sont pas dopées.

3. Procédé suivant la revendication 1 ou 2, comprenant, en outre, implanter (25) des ions dans une région autour du dispositif (26, 27, 28, 29) de fréquence radio pour former une région riche en défauts, afin de réduire une densité de porteurs de charge libres après la formation de la région d'isolation.

4. Procédé suivant la revendication 3, dans lequel implanter (25) des ions comprend implanter des ions argon.

5. Procédé suivant la revendication 1 ou 2, comprenant, en outre, implanter (25) des ions dans au moins certaines des régions (42) de matière de charge de silicium et/ou des régions (43) de matière de charge de polysilicium pour former des régions riches en défauts, afin de réduire une densité de porteurs de charge libres.

6. Dispositif comprenant :
un substrat (20, 21, 22, 23) silicium sur isolateur,
un dispositif (26, 27, 28, 29) de fréquence radio à une couche (24) active du substrat (20, 21, 22, 23) silicium sur isolateur dans la couche (24) active, une région (41) d'isolation autour du dispositif (26, 27, 28, 29) de fréquence radio,
des régions (42) de matière de charge de silicium dans la région (41) d'isolation, et
des régions (43) de matière de charge de polysilicium au-dessus de la région (41) d'isolation, dans lequel les régions (43) de matière de charge de polysilicium sont prévues en des positions différentes de celles des régions (42) de matière de charge de silicium dans une vue de dessus du substrat,
dans lequel les régions (42) de matière de charge de silicium ne sont pas dopées.

7. Dispositif suivant la revendication 6, dans lequel les régions (43) de matière de charge de polysilicium ne sont pas dopées.

8. Dispositif suivant la revendication 6 ou 7, comprenant en outre, une région riche en défauts autour du dispositif (26, 27, 28, 29) de fréquence radio, dans lequel la région (41) d'isolation est à recouvrement au moins en partie avec la région riche en défauts.

9. Dispositif suivant la revendication 8, dans lequel la région riche en défauts comprend une région implantée d'ions.
